Europäisches Patentamt

European Patent Office

Office européen des brevets

(19)

(11) Numéro de publication: **0 020 263**
**B1**

(12) **FASCICULE DE BREVET EUROPEEN**

(45) Date de publication du fascicule du brevet: **18.05.83**

(21) Numéro de dépôt: **80400748.2**

(22) Date de dépôt: **28.05.80**

(51) Int. Cl.³: **G 11 C 29/00,**
**G 11 C 19/08**

(54) Machine de test de mémoires à bulles et procédé de test utilisant une telle machine.

(30) Priorité: **01.06.79 FR 7914126**

(43) Date de publication de la demande:
**10.12.80 Bulletin 80/25**

(45) Mention de la délivrance du brevet:
**18.05.83 Bulletin 83/20**

(84) Etats contractants désignés:
**CH DE GB LI**

(56) Documents cités:
**FR - A - 2 391 532**

**IEEE TRANSACTIONS ON MAGNETICS, vol. 12,
no. 1, janvier 1976, New York, US GERGIS et al.
"The effect of DC in plane field on the operation
of field access bubble memory devices", page
7—14.**

(73) Titulaire: **COMMISSARIAT A L'ENERGIE
ATOMIQUE Etablissement de Caractère
Scientifique Technique et Industriel
B.P. 510
F-75752 Paris Cedex 15 (FR)**

(72) Inventeur: **Mauduit, Daniel
Charnecles
F-38140 Rives sur Fure (FR)**
Inventeur: **Sauron, Georges
4, Allée des Saules
F-38240 Meylan (FR)**

(74) Mandataire: **Mongrédien, André et al,
c/o BREVATOME 25, rue de Ponthieu
F-75008 Paris (FR)**

Courier Press, Leamington Spa, England.

## Machine de test de mémoires à bulles et procédé de test utilisant une telle machine

L'invention concerne une machine destinée à tester des éléments à bulles magnétiques tels que des mémoires, ainsi qu'un procédé de test utilisant une telle machine.

Rappelons qu'on appelle traditionnellement "bulles" des domaines magnétiques, en général cylindriques, créés dans un film magnétique plan définissant une couche monocristalline présentant une anisotropie magnétique uniaxiale perpendiculaire au plan de la couche, l'induction magnétique de ces domaines cylindriques possédant un sens opposé à celui qu'elle présente dans le reste de la couche. Ces domaines magnétiques présentent la particularité de pouvoir être déplacés dans la couche lorsque celle-ci est revêtue de motifs métalliques aimantables (par exemple en "permalloy") assurant le guidage des domaines magnétiques. La stabilité des bulles résulte de l'application d'un champ de polarisation parallèle à la direction d'aimantation du film magnétique, c'est-à-dire perpendiculaire au plan de ce film, tandis que le déplacement de ces domaines est obtenu au moyen d'un champ tournant parallèle à ce plan grâce auquel les motifs métalliques formés sur le film magnétique sont aimantés, de telle sorte que les domaines magnétiques viennent se placer à l'endroit où la composante verticale du champ de fuite est maximale et de sens opposé au champ de polarisation, et peuvent être déplacés en faisant tourner ce champ de façon à modifier les pôles magnétiques formés sur les motifs métalliques aimantés.

On peut ainsi réaliser des circuits logiques, des comparateurs, des mémoires, etc.

Comme tous les composants électroniques, les éléments à bulles magnétiques doivent être testés après leur fabrication de façon notamment à contrôler leurs performances et à détecter d'éventuels défauts de fabrication.

Une machine de test d'éléments à bulles magnétiques doit comprendre une tête magnétique permettant de créer le champ de polarisation et le champ tournant nécessaires au fonctionnement de l'élément à tester, ainsi qu'un dispositif de test proprement dit permettant d'appliquer les tensions et de faire circuler les courants nécessaires ainsi que d'effectuer les mesures et les observations nécessaires.

On connaît actuellement différentes machines de test d'éléments à bulles magnétiques de ce type. Cependant, aucune de ces machines ne permet de réaliser un test en continu d'éléments à bulles magnétiques de moyenne ou de grande dimension, en raison des conditions souvent contradictoires imposées par les caractéristiques magnétiques de la tête magnétique et par les contraintes mécaniques liées notamment à l'accessibilité du film magnétique testé et à la disposition du dispositif de test par rapport à la tête magnétique.

Ainsi, la tête magnétique doit délivrer simultanément un champ de polarisation continu perpendiculaire au plan du film magnétique compris entre 100 oe et 300 oe, et un champ tournant situé dans le plan du film magnétique, de fréquence comprise entre 1 Hz et 200 kHz, et d'amplitude comprise entre 10 oe et 70 oe.

Si la création du champ de polarisation ne pose guère de problèmes et peut être réalisée aisément au moyen de deux bobines placées en position de Helmholtz, la création du champ tournant est plus difficile. En effet, le champ tournant est créé au moyen de deux paires de bobines alimentées par deux courants sinusoïdaux déphasés de $\pi/2$, et qui ne peuvent pas être placées en position de Helmholtz, ce qui rend impossible la création d'un champ tournant homogène dans le volume du film magnétique à tester. En outre, la self des bobines délivrant le champ tournant prend d'autant plus d'importance que la fréquence de ce champ est grande, ce qui limite très rapidement la dimension des bobines ou la fréquence de travail. De plus, le champ tournant délivré par ces bobines comprend, en plus de la composante située dans le plan du film magnétique, une composante perpendiculaire à ce plan qui perturbe le fonctionnement de l'élément à tester.

En raison du caractère non homogène du champ tournant délivré par la tête magnétique, afin de tenir compte des difficultés inhérentes à la création de ce champ tournant et pour les concilier avec les conséquences mécaniques qui en résultent quant à la disposition des bobines de la tête magnétique par rapport au film à tester, les machines de test connues sont limitées aux test de films magnétiques de petite dimension et ne permettent pas toujours de réaliser des tests en continu.

Ainsi, les machines existant actuellement exigent généralement le découpage préalable des couches de grande surface, appelée "tranche", en petites parties portant chacune un dispositif élémentaire, appelées "puces". Chaque "puce", destinée à prendre place dans un boîtier d'application de champs comportant notamment un blindage cylindrique et des aimants permanents, doit ensuite être équipée de conducteurs de commande et/ou de sortie avant d'être disposée dans le "boîtier test" muni de jeux de bobines de polarisation et de champ tournant aptes à la placer dans les conditions de fonctionnement, et les conducteurs sont réunis à l'électronique de test. L'ensemble des opérations correspondant à un test complet est donc effectué sur chaque puce, bonne ou mauvaise.

L'art antérieur peut être illustré par la demande française publiée sous le numéro 2 391 532 et par l'article de I.S. Gergis et autres, paru dans: "IEEE Transactions on Magnetics" Vol. Mag-12, No. 1, Janvier 1976, pages 7—13.

La présente invention a pour but la réalisation d'une machine de test de films magnétiques plans à bulles magnétiques permettant de tester en continu des films magnétiques plans de grandes dimensions, pouvant atteindre par exemple 10 cm de diamètre et autorisant un accès facile au film magnétique à tester ainsi qu'une visualisation des opérations de tests. La visualisation permet en effet de contrôler la mise en place correcte du dispositif de test, tel qu'un dispositif de test à pointes, ainsi que la continuité des conducteurs, et permet d'observer le déplacement des domaines magnétiques par effet Kerr lorsque le film magnétique comporte une couche réfléchissante sur sa face inférieure. En outre, conformément à l'invention, la composante perpendiculaire au plan du film magnétique du champ tournant créé par la tête magnétique n'excède jamais 2% de ce champ, ce qui permet de ne pas perturber le fonctionnement de l'élément à tester.

Dans ce but, il est proposé une machine de test de films magnétiques plans à bulles magnétiques, ladite machine comprenant un dispositif de test et une tête magnétique, caractérisée en ce que la tête magnétique comporte deux bobines de polarisation en position de Helmholtz et dont l'axe commun est normal au plan du film magnétique, et deux bobines plates d'axes perpendiculaires entre eux et parallèles au plan du film magnétique destinés à créer le champ tournant nécessaire au déplacement des domaines magnétiques à l'intérieur dudit film, une première des bobines de polarisation étant disposée à l'intérieur des bobines plates, celles-ci étant elles-mêmes disposées à l'intérieur l'une de l'autre et d'un même côté du film magnétique, tandis que le dispositif de test et la seconde bobine de polarisation sont disposés de l'autre côté du film magnétique.

Grâce à la disposition particulière des bobines constituant la tête magnétique selon l'invention et à la disposition du dispositif de test par rapport à ces bobines, la machine de test selon l'invention permet d'atteindre les objectifs énoncés précédemment tout en présentant des caractéristiques magnétiques permettant de répondre aux exigences imposées à de telles machines. La machine selon l'invention permet notamment d'effecteur des test statiques (vérification de la continuité et de la résistance des conducteurs) et des tests dynamiques (vérification de la continuité des chaînes de propagation des bulles et de leur bonne propagation) sur la "tranche" complète.

Conformément à une autre caractéristique de l'invention, la tête magnétique comprend, de plus, un blindage disposé à l'intérieur des bobines plates, du côté de la première bobine de polarisation opposé au film magnétique. Ce blindage permet d'éliminer la composante horizontale du champ tournant due à la partie des bobines plates opposée au film magnétique, par effet image.

Conformément à une autre caractéristique de l'invention, les deux bobines plates et la première bobine de polarisation sont disposées à l'intérieur d'un caisson étanche dans lequel circule un fluide à constante diélectrique élevée. Cette disposition permet d'assurer le refroidissement des bobines et de stabiliser la température à la valeur souhaitée.

Conformément à une caractéristique secondaire de l'invention, la machine de test comprend de plus un plateau mince disposé entre les bobines plates d'une part et le dispositif de test et la seconde bobine de polarisation d'autre part, ce plateau mince étant perpendiculaire à l'axe des bobines de polarisation et mobile dans son plan, de façon à supporter le film magnétique et à permettre de tester celui-ci en continu. Dans ce cas, la machine comprend alors, de préférence, un dispositif à dépression au moyen duquel le film magnétique est maintenu sur le plateau mince.

Selon un mode de réalisation particulier de l'invention, le dispositif de test comprend une carte à pointes portée par un support susceptible de se déplacer selon une direction normale au plan du film magnétique. La machine comprend alors, de préférence, des moyens de relevage du support permettant d'accéder au plateau mince supportant le film magnétique.

Selon une autre caractéristique de l'invention, la machine de test comprend, de plus, des moyens de visualisation disposés le long de l'axe commun des bobines de polarisation, du même côté du film magnétique que la seconde bobine de polarisation.

Selon encore une autre caractéristique de l'invention, la machine de test comprend, de plus, des moyens de réglage en hauteur et de calage de la tête magnétique.

L'invention a également pour objet un procédé de test de films magnétiques à bulles magnétiques comprenant plusieurs mémoires élémentaires à bulles magnétiques, ce procédé étant caractérisé en ce que l'on analyse séquentiellement chacune des mémoires élémentaires à l'aide de la machine de test définie précédemment, en ce qu'on découpe dans le film magnétique chacune des mémoires élémentaires et en ce qu'on élimine les mémoires élémentaires défectueuses avant de procéder si nécessaire à d'autres tests individuels sur chacune des mémoires élémentaires restantes.

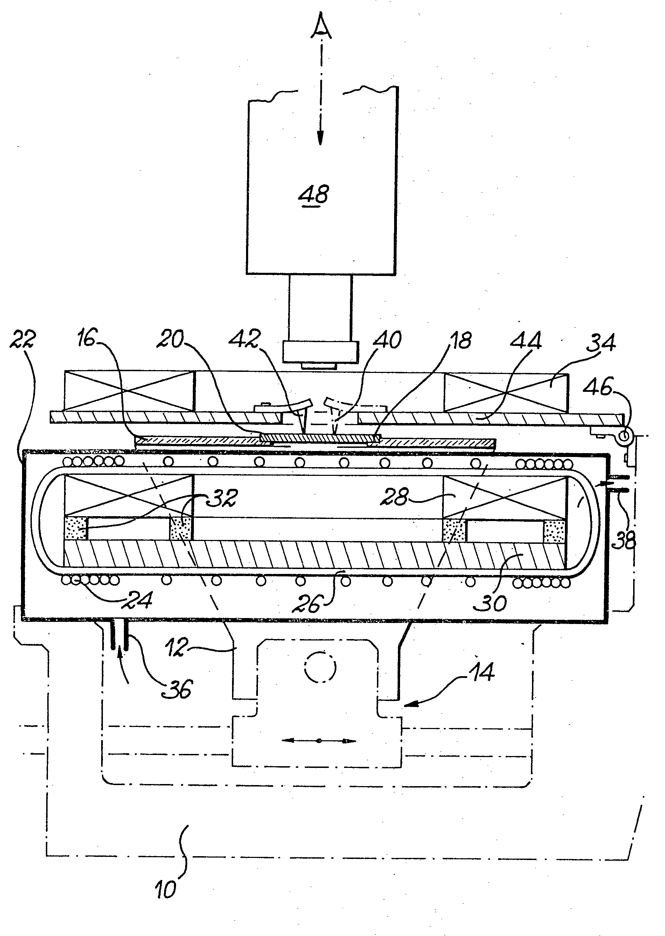

On décrira maintenant, à titre d'exemple non limitatif, un mode de réalisation particulier de l'invention en se référant au dessin annexé dans lequel la figure unique représente, en coupe transversale et de façon schématique, une machine de test réalisée conformément aux enseignements de la présente invention.

La machine de test représentée sur la figure comprend un bâti-support antivibratoire 10, représenté en traits mixtes, sur lequel est montée une table 12, par l'intermédiaire de moyens connus permettant de déplacer cette table en X et Y dans un plan horizontal, ces moyens étant désignés par la référence 14. La table 12 porte un plateau mince et rigide 16, disposé dans un plan horizontal, et pourvu dans sa partie centrale d'un logement 18 dans lequel est disposé le film magnétique plan à bulles magnétiques 20 que l'on désire tester. De préférence, le film 20 est maintenu sur le plateau 16 par un dispositif à dépression (non représenté) dont les orifices d'aspiration débouchent dans le logement 18.

Conformément à l'invention, le plateau mince 16 est fixé au support 12 par ses deux extrémités, de façon à définir entre le bâti 10 et le plateau 16 un espace dans lequel est reçu un caisson étanche 22 supporté par le bâti 10. Le caisson étanche 22 contient deux bobines plates 24 et 26 emboîtiées l'une dans l'autre et dont les axes sont perpendiculaires entre eux et parallèles au plan du film magnétique 20. Les bobines plates 24 et 26 sont destinées à créer le champ tournant nécessaire au déplacement des domaines magnétiques à l'intérieur du film 20.

Une première bobine de polarisation 28, d'axe perpendiculaire au plan du film magnétique 20, est disposée à l'intérieur des bobines 24 et 26, à proximité des nappes de celles-ci les plus proches du film 20, et un blindage magnétique 30 est disposé à l'intérieur des bobines 24 et 26 entre la bobine 28 et les nappes des bobines 24 et 26 les plus éloignées du film magnétique 20. De préférence, la bobine 28 et le blindage 30 sont séparés par des cales 32. Une seconde bobine de polarisation 34, identique à la bobine 28, est disposée à l'extérieur du caisson étanche 22 audessus du plateau 16, de telle sorte que le film magnétique à tester 20 soit disposé sensiblement à égale distance des bobines 28 et 34, celles-ci étant placées en position de Helmholtz et leur axe commun étant perpendiculaire au plan du film 20. Les bobines de polarisation 28 et 34 sont destinées à créer un champ de polarisation perpendiculaire au plan du film 20.

Les bobines plates 24 et 26, d'une part, et les bobines de polarisation 28 et 34, d'autre part, ainsi que le blindage 30, définissent la tête magnétique de la machine de test selon l'invention.

De préférence, les bobines plates 24 et 26 sont constituées par deux nappes de fils de Litz, ou fils multibrins. Les bobines sont alors formées de fils isolés entre eux et soudables, réalisés par exemple en cuivre émaillé, ces fils étant toronnés entre eux et l'ensemble des bobines étant ensuite protégé par un ou deux guipages de soie naturelle. Le fil de Litz présente une surface plus importante pour un diamètre identique à celui d'un fil monobrin, ce qui permet de diminuer l'effet de peau et les pertes qui en découlent à la fréquence de fonctionnement, ainsi que la capacité répartie entre les deux bobinages, de sorte que la montée en fréquence est facilitée.

Le blindage 30, qui a pour fonction de renforcer le champ magnétique créé par les bobines plates 24 et 26 au niveau du film magnétique 20, par effet image, et d'éliminer la composante horizontale de ce champ due aux nappes inférieures des bobines 24 et 26, est réalisé de préférence en ferrite doux de manganèse et de zinc à perméabilité élevée et à faibles pertes. L'épaisseur du blindage 30 est déterminée en tenant compte à la fois de son efficacité et de son point de saturation par le champ tournant créé par les bobines 24 et 26. Un compromis entre ces deux grandeurs conduit à limiter l'épaisseur du blindage à une valeur maximale de 3 mm.

De préférence, les dimensions des nappes des bobines 24 et 26 sont calculées de telle sorte que la composante verticale du champ tournant créé par des bobines soit inférieure à 2% du champ maximal appliqué sur la plus grande surface susceptible d'être occupée par un plot du film magnétique 20. En effet, des essais ont montré que ce pourcentage représente la limite de la valeur de la composante verticale admissible pour que le fonctionnement de l'élément à bulles magnétiques ne soit pas perturbé. La surface maximale occupée par un plot étant pratiquement égale à $10 \times 10$ mm², la dimension des nappes des bobines 24 et 26 se trouve ainsi fixée à $120 \times 120$ mm².

En raison des puissances dissipées dans les bobines plates 24 et 26 et dans la bobine 28, qui sont respectivement de l'ordre de 40 Watts et de 12 Watts, il est nécessaire de refroidir ces bobines. Dans ce but, un liquide à constante diélectrique élevée circule dans le caisson étanche 22, entre un orifice d'entrée 36 et un orifice de sortie 38. Ce liquide de refroidissement permet de maintenir la température à un niveau constant quelle que soit la puissance dissipée par les bobines.

Conformément à l'invention, la machine de test comprend également un dispositif de test représenté schématiquement en 40, tel qu'un dispositif de test à pointes comprenant, par exemple, des cartes amovibles dont les pointes 42 sont reliées à un système électronique de test externe (non représenté) apte à appliquer les tensions ou courants de commande nécessaires aux tests et à mesurer les signaux caractéristiques du fonctionnement. Les pointes 42 sont susceptibles d'être amenées en contact avec des plots conducteurs formés sur le film magnétique à tester 20. Dans ce but, le dispositif de test 40 peut se déplacer verticalement par rapport au film magnétique à bulles 20, entre une position de contact des pointes 42 avec les plots formés sur le film 20, représentée sur la figure, une position basse proche de cette position de contact et permettant d'effectuer les déplacements en X et Y du plateau 16 au moyen du dispositif 14, et une position haute permettant d'accéder au film 20 et, en particulier de le remplacer par un autre film à tester. A cet effet, la machine selon l'invention comprend un plateau 44 sur lequel est reçu les dispositif de test 40, ce plateau 44 étant relié au bâti-support 10 par des moyens de relevage constitués, dans le mode de réalisation représenté, par une articulation 46 située sensiblement dans le plan du film 20, de façon à effectuer un déplacement du dispositif 40 sensiblement normal à ce dernier à proximité du film 20. Comme le montre la figure, le plateau 44 supporte, de plus, la bobine de polarisation 34.

Grâce à la disposition qui vient d'être décrite, la machine de test selon l'invention permet de tester en continu des films magnétiques à bulles 20 de grandes dimensions, tout en autorisant un accès facile à ces films et en permettant une visualisation des pointes 42 du dispositif de test 40, et de la partie centrale du film 20 grâce à des moyens de visualisation 48 constitués, par exemple, par un microscope, une caméra et un moniteur. Ces moyens de visualisation 48 sont disposés le long de l'axe commun des bobines de polarisation 28 et 34 et du même côté du film magnétique 20 que la bobine 34. Ils permettent à la fois de contrôler l'efficacité du contact entre les pointes 42 et les plots formés sur le film 20, de contrôler la continuité des conducteurs et enfin d'observer le déplacement des domaines magnetiques par effet Kerr lorsque le film 20 comporte une couche réfléchissante sur sa face inférieure. Cette dernière possibilité permet d'observer les déformations des domaines magnétiques, et notamment les variations de leurs diamètres en fonction de l'amplitude du champ et de la position par rapport au centre des bobines. Il est ainsi possible de connaître l'évolution de la composante verticale du champ tournant et, notamment, de vérifier que celle-ci reste inférieure à 2% de la valeur du champ.

La machine de test selon l'invention peut également comprendre un dispositif de réglage en hauteur et de calage (non représenté) du caisson étanche 22 comprenant la partie inférieure de la tête magnétique. Ce dispositif permet de régler parfaitement le positionnement du plan supérieur des bobines 24, 26 et 28 par rapport au plan défini par le film à tester 20.

Le film magnétique 20 constitue une "tranche" complète comportant un certain nombre de "puces" élémentaires. Dans chaque puce, il est prévu un certain nombre de registres en excès. Lorsque le film 20 est testé dans la machine qui vient d'être décrite elle est d'abord utilisée pour tester le nombre de registres de chaque puce en état de marche. Lorsque le nombre de registres défectueux est supérieur au nombre de registres en excès, la puce est défectueuse. Elle est alors identifiée et repérée, afin d'être éliminée par découpage.

Les puces restantes sont alors soumises individuellement à un test en température (méthode d'échantillonnage).

Seules les puces reconnues bonnes sont soumises aux test suivants (mesure de champ magnétique de fonctionnement). On détermine enfin la zone de fonctionnement ou marge de chaque puce.

On voit que la machine, selon l'invention, permet ainsi de faire rapidement et automatiquement un tri des puces mauvaises de la tranche et d'éviter d'appliquer l'ensemble de la batterie de tests à ces puces mauvaises. Grâce à l'utilisation du dispositif à pointes 42, cette machine élimine en outre la nécessité de monter les puces avant test.

Bien entendu, l'invention n'est pas limitée au mode de réalisation qui vient d'être décrit à titre d'exemple, mais en comprend toutes les variantes. Ainsi, les moyens 14 permettant de déplacer le plateau 16 sur lequel est fixé le film magnétique 20 à tester peuvent être constitués par tous moyens connus permettant de réaliser avec précision un déplacement en X et Y, et l'articulation 46, permettant de faire basculer le plateau 44 de façon à autoriser un accès facile au film à tester, peut être remplacée par tout autre moyen connu permettant de déplacer le dispositif de test 40 verticalement par rapport au plan du film 20. Le dispositif de test 40, constitué dans le mode de réalisation représenté par un dispositif de test à pointes, peut également être constitué pac tout autre dispositif de test connu susceptible d'être raccordé à un système de test électronique externe d'un type quelconque.

**Revendications**

1. Machine de test de films magnétiques plans à bulles magnétiques, ladite machine comprenant un dispositif de test et une tête magnétique, caractérisée en ce que la tête magnétique comporte deux bobines (28, 34) de polarisation en position de Helmholtz et dont l'axe commun est normal au plan du film (20) magnétique, et deux bobines (24, 26) plates d'axes perpendiculaires entre eux et parallèles au plan du film magnétique destinées à créer le champ tournant nécessaire au déplacement des domaines magnétiques à l'intérieur dudit film, une première (28) des bobines de polarisation étant disposée à l'interieur des bobines plates, celles-ci étant elles-mêmes disposées à l'intérieur l'une de l'autre et d'un même côté du film magnétique, tandis que le dispositif (40) de test et la seconde bobine (34) de polarisation sont disposés de l'autre côté du film magnétique.

2. Machine de test selon la revendication 1, caractérisée en ce que la tête magnétique comprend, de plus, un blindage (30) disposé à l'intérieur des bobines (24, 26) plates, du côté de la première bobine (28) de polarisation opposé au film magnétique.

3. Machine de test selon l'une quelconque des revendications 1 ou 2, caractérisée en ce que les deux bobines plates et la première bobine de polarisation sont disposées à l'intérieur d'un caisson (22) étanche dans lequel circule (36, 38) un fluide à constante diélectrique élevée.

4. Machine de test selon l'une quelconque des revendications précédentes, caractérisée en ce qu'elle comprend, de plus, un plateau (16) mince disposé entre les bobines plates, d'une part, et le dispositif de test et la seconde bobine de polarisation, d'autre part, ce plateau mince étant perpendiculaire à l'axe des bobines de polarisation et mobile dans son plan, de façon à supporter le film magnétique.

5. Machine de test selon la revendication 4, caractérisée en ce qu'elle comprend, de plus, un dispositif à dépression au moyen duquel le film magnétique est maintenu sur le plateau mince.

6. Machine de test selon l'une quelconque des revendications précédentes, caractérisée en ce que le dispositif (40) de test comprend une carte à pointes (42) portée par un support (44) susceptible de se déplacer selon une direction normale au plan du film magnétique.

7. Machine de test selon la revendication 6, caractérisée en ce qu'elle comprend des moyens (46) de relevage du support permettant d'accéder au plateau mince supportant le film magnétique.

8. Machine de test selon l'une quelconque des revendications précédentes, caractérisée en ce qu'elle comprend, de plus, des moyens (48) de visualisation disposés le long de l'axe commun des bobines de polarisation, du même côté du film magnétique que la seconde bobine de polarisation.

9. Machine de test selon l'une quelconque des revendications précédentes, caractérisée en ce qu'elle comprend, de plus, des moyens de réglage en hauteur et de calage de la tête magnétique.

10. Procédé de test de films magnétiques à bulles magnétiques comprenant plusieurs mémoires élémentaires à bulles magnétiques, caractérisé en ce que l'on analyse séquentiellement chacune des mémoires élémentaires à l'aide de la machine de test selon l'une quelconque des revendications 1 à 9, en ce qu'on découpe dans le film magnétique chacune des mémoires élémentaires et en ce qu'on élimine les mémoires élémentaires défectueuses avant de procéder si nécessaire à d'autres test individuels sur chacune des mémoires élémentaires restantes.

**Patentansprüche**

1. Maschine zum Prüfen von ebenen Magnetblasenspeicherfilmen, mit einer Prüfeinrichtung und einem Magnetkopf, dadurch gekennzeichnet, daß der Magnetkopf zwei in einer Anordnung nach Helmholtz angeordnete Polarisationsspulen (28, 34), deren gemeinsame Achse normal zur Ebene des Magnetfilms (20) ausgerichtet ist, sowie zwei mit ihren Achsen lotrecht zueinander und parallel zur Ebene des Magnetfilms ausgerichtete Flachspulen (24, 26) zum Erzeugen des für die Verlagerung der magnetischen Zonen innerhalb des Magnetfilms notwendigen rotierenden Feldes aufweist, daß eine erste Polarisationsspule (28) innerhalb der Flachspulen angeordnet ist, welche ihrerseits ineinander und an ein und derselben Seite des Magnetfilms angeordnet sind, und daß die Prüfeinrichtung (40) sowie die zweite Polarisationsspule (34) an der anderen Seite des Magnetfilms angeordnet sind.

2. Maschine nach Anspruch 1, dadurch gekennzeichnet, daß an der dem Magnetfilm abgewandten Seite der ersten Polarisationsspule (28) eine Abschirmung (30) innerhalb der Flachspulen (24, 26) angeordnet ist.

3. Maschine nach einem der Ansprüche 1 oder 2, dadurch gekennzeichnet, daß die beiden Flachspulen und die erste Polarisationsspule in einem von einem Strömungsmittel mit erhöhter Dielektrizitätskonstante durchströmten (36, 38), dichten Gehäuse (22) enthalten sind.

4. Maschine nach einem der vorstehenden Ansprüche, dadurch gekennzeichnet, daß zwischen den Flachspulen einerseits und der Prüfeinrichtung und der zweiten Polarisationsspule andererseits eine dünne Scheibe (16) lotrecht zur Achse der Polarisationsspulen angeordnet ist, welche in ihrer Ebene verschieblich ist und den Magnetfilm trägt.

5. Maschine nach Anspruch 4, dadurch gekennzeichnet, daß sie eine Unterdruckeinrichtung aufweist, mittels welcher der Magnetfilm auf der dünnen Scheibe festgehalten ist.

6. Maschine nach einem der vorstehenden Ansprüche, dadurch gekennzeichnet, daß die Prüfeinrichtung (40) eine Nadelkarte (42) aufweist, welche von einer in einer zur Ebene des Magnetfilms normalen Richtung bewegbaren Halterung (44) getragen ist.

7. Maschine nach Anspruch 6, dadurch gekennzeichnet, daß sie Einrichtungen (46) zum Anheben der Halterung für den Zugang zu der den Magnetfilm tragenden dünnen Scheibe aufweist.

8. Maschine nach einem der vorstehenden Ansprüche, dadurch gekennzeichnet, daß sie eine Beobachtungseinrichtung (48) aufweist, welche an der gleichen Seite des Magnetfilms wie die zweite Polarisationsspule entlang der gemeinsamen Achse der Polarisationsspulen angeordnet ist.

9. Maschine nach einem der vorstehenden Ansprüche, dadurch gekennzeichnet, daß sie Einrichtungen für die Höhenverstellung und zum Feststellen des Magnetkopfs aufweist.

10. Verfahren zum Prüfen von jeweils eine Anzahl von Magnetblasen-Elementarspeichern aufweisenden Magnetfilmen, dadurch gekennzeichnet, daß man die einzelnen Elementarspeicher mittels einer Prüfmaschine nach wenigstens einem der Ansprüche 1 bis 9 nacheinander prüft, daß man die einzelnen Elementarspeicher aus dem Magnetfilm herausschneidet und daß man fehlerhafte Elementarspeicher aussondert, bevor man die übrigen Elementarspeicher, sofern notwendig, einzeln weiteren Prüfunden unterwirft.

## Claims

1. Test apparatus for flat magnetic films of magnetic bubbles, said apparatus comprising a testing means and a magnetic head, characterized in that the magnetic head comprises two polarisation coils (28, 34) in the Helmholtz position whose common axis is normal to the plane of the magnetic film (20), and two flattened coils (24, 26) whose axes are mutually perpendicular and parallel to the plane of the magnetic film, for providing the rotating filed necessary for displacement of magnetic domains in the interior of said film, the first polarisation coil (28) being located within the flattened coils, which are themselves located one inside the other and on the same side of the magnetic film, whereas the testing means (40) and the second polarisation coil (34) are located on the other side of the magnetic film.

2. Test apparatus according to Claim 1 characterized in that the magnetic head additionally comprises a shield (30) located within the flattened coils (24, 26) and on that side of the first polarisation coil (28) which is distant from the magnetic film.

3. Test apparatus according to either of Claims 1 and 2 characterized in that the two flattened coils and the first polarisation coil are located within an enclosed vessel within which circulates (36, 38) a fluid of elevated dielectric constant.

4. Test apparatus according to any one of the preceding Claims characterized in that it additionally comprises a thin platen (16) located between the flattened coils, on the one hand, and the testing means and second polarisation coil, on the other hand, said thin platen being perpendicular to the axis of the polarisation coils, and movable within its own plane, whereby to support the magnetic film.

5. Test apparatus according to Claim 4 characterised in that it additionally comprises suction means whereby the magnetic film may be held on the thin platen.

6. Test apparatus according to any one of the preceding Claims characterized in that the testing means (40) a set of contacts (42) carried on a support (44) displaceable in a direction normal to the plane of the magnetic film.

7. Test apparatus according to Claim 6 characterized in that it comprises lifting means (46) for the support, permitting access to the thin platen supporting the magnetic film.

8. Test apparatus according to any one of the preceding Claims characterized in that it additionally comprises visualization means (48) located on the common axis of the polarisation coils, on the same side of the magnetic film as the second polarisation coil.

9. Test apparatus according to any one of the preceding Claims characterized in that it additionally comprises means for adjusting the height and the setting of the magnetic head.

10. Process for testing magnetic films of magnetic bubbles comprising a plurality of memory elements of magnetic bubbles, characterized in that each of the memory elements is analyzed in sequence by means of test apparatus according to any one of Claims 1 to 9, and in that each of the memory elements is punched out of the magnetic film, and defective elements are eliminated before proceeding, if necessary to other individual tests on each of the remaining memory elements.